# EUROPEAN PATENT APPLICATION

(11) **EP 2 242 033 A1**
(43) Date of publication of application: **20.10.2010**
(21) Application number: 10001708.6
(22) Date of filing: 19.02.2010
(51) Int. Cl.: G09F 7/04, G09F 9/30

(54) **Flexible display screen**

(30) Priority: 17.04.2009 CN 200920130782 U
(71) Applicant: Yuen, Ronald Sik Hung, Tokwawan Kowloon Hong Kong (HK)
(72) Inventor: Yuen, Sik Hung, Kowloon Hong Kong (CN); Wang, Haoran, Kowloon Hong Kong (CN); Chow, Kenny Wing Yip, Kowloon Hong Kong (CN)
(74) Representative: Hauge, Sidsel

(57) **Abstract**

The present invention relates to a flexible display screen composed of a plurality of flexible display modules jointed side by side, each of said flexible display modules comprising a flexible circuit board, which is fixedly arranged with a plurality of display chips on its front face, and a plurality of magnets on its back face, so that said flexible display screen can be attracted on a metal medium by means of said magnets, so that said flexible display screen can be attracted on a metal medium by means of said magnets, wherein the magnets are distributed at least on the perimeter of the back face of the flexible circuit board in such a way that the joining sides of two adjoining flexible circuit boards are arranged respectively and symmetrically with a same number of magnets, and each pair of magnets disposed on the respective joining sides having opposite polarity orientations. During the assembly of the flexible display screen according to the present invention, each flexible display module can be guided to joint with each other under the action of a specially-arranged magnetic attraction, avoiding the mis-arrangement during the assembly, so as to realize an easy and correct assembly. Furthermore, under the action of the magnetic attraction, the gap between the adjoining flexible display modules is reduced, allowing a larger tension of the flexible display module when it is attached to the medium, so as to improve the display effect of the flexible display screen and the overall quality and the visualization of the product.

## Description

### FIELD OF THE INVENTION

The present invention relates to a display device, particularly to a flexible display screen.

### BACKGROUND OF THE INVENTION

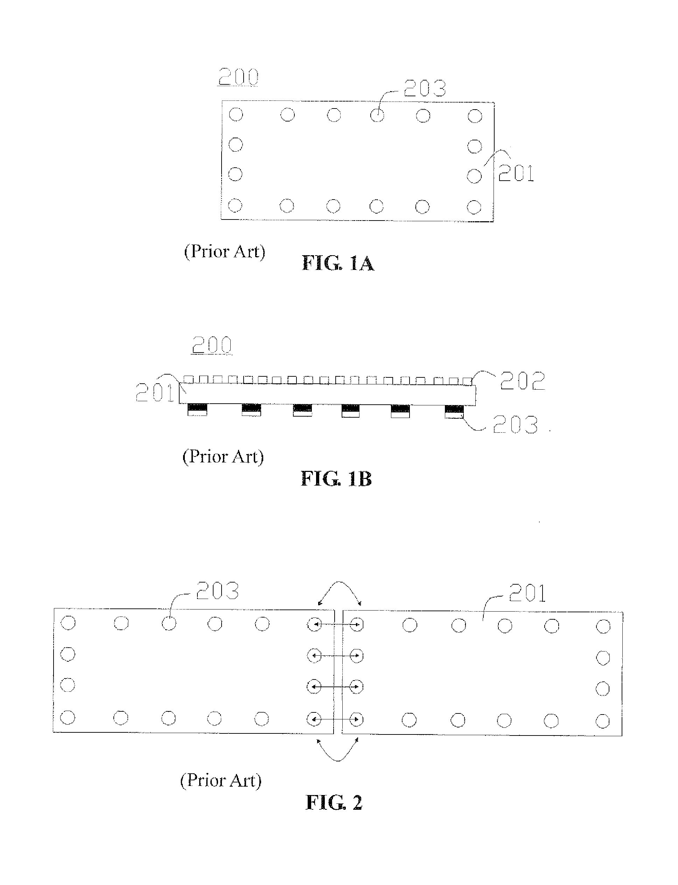

Flexible display screen is a novel ultra-thin flexible display system, which has exquisite protruding lines for installation and varieties of special structures and is suitable for decorations or advertisements of irregular carriers such as buildings, cars or the like, and thus is favored increasingly by many customers. As shown in Figs. 1A, 1B, 2 and 3, a LED flexible display screen of the prior art is composed of a number of LED flexible display modules 200 jointed side by side. Each LED flexible display module 200 comprises a flexible circuit board 201 with a plurality of LED chips 202 fixed on its front face and a plurality of magnets 203 fixed on its back face. The flexible display screen can be fixed by these magnets 203 being attracted to a metal medium (e.g. a sheet) 300 that can be fixed on the carrier such as building or the like.

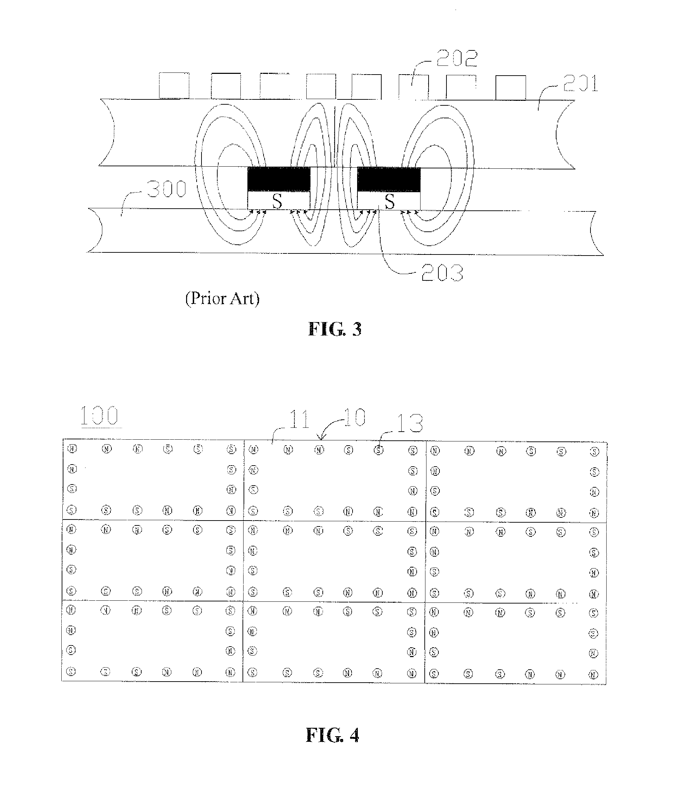

The magnets 203 are distributed on the perimeter of the back face of the flexible circuit board 201. Each magnet 203 comprises two poles, i.e., a north pole N at its one end and a south pole S at it's the other end. As shown in Figs. 2 and 3, the magnets 203 fixed on the flexible circuit board 201 of the prior art have the same polarity orientation. That is, all magnets 203 are fixed on the flexible circuit board 201 at their north poles N with their south poles S orientated outward, and are attracted on the metal medium 300 at the south poles S. Each magnet 203 can generate a magnetic field. A large magnetic repulsion is generated between each pair of magnets 203 fixed on respective jointing sides of two adjoining flexible circuit boards 201 due to their same polarity orientation. Such repulsion is inclinable to cause a mis-arrangement of the LED flexible display modules 200 during assembling, a widen gap between the adjoining LED flexible display modules 200, and a lack in tension when the flexible display modules being attached to the medium, decreasing thus the quality and the visualization of the product.

In all, said flexible display screen of the prior art is necessary to be improved due to its inconvenience and drawbacks in application.

### SUMMARY OF THE INVENTION

To overcome at lease one of the above drawbacks, it is the object of the present invention to provide a flexible display screen, which can be assembled easily and correctively and can improve the overall quality and visualization of the product.

The object is achieved by providing a flexible display screen composed of a plurality of flexible display modules jointed side by side, each of said flexible display modules comprising a flexible circuit board, which is fixedly arranged with a plurality of display chips on its front face, and a plurality of magnets on its back face, so that said flexible display screen can be attracted on a metal medium by means of said magnets, wherein the magnets are distributed at least on the perimeter of the back face of the flexible circuit board in such a way that the joining sides of two adjoining flexible circuit boards are arranged respectively and symmetrically with a same number of magnets, and each pair of magnets disposed on the respective joining sides having opposite polarity orientations.

According to one aspect of the flexible display screen of the invention, said flexible display screen is formed by jointing side by side the flexible circuit boards of said flexible display modules.

According to another aspect of the flexible display screen of the invention, at least one flexible circuit board is configured to have a polygonal shape.

According to yet another aspect of the flexible display screen of the invention, at least one flexible circuit board is configured to have a rectangular shape or a square shape.

According to a further aspect of the flexible display screen of the invention, each side of the back face of the flexible circuit board is arranged with an even number of magnets, in which the numbers of the magnets with different polarity orientations are same.

According to a further aspect of the flexible display screen of the invention, the polarity orientations of the magnets arranged on the perimeter of the back face of each single flexible circuit board are same, while the polarity orientations of the magnets on the perimeters of the back faces of two adjoining flexible circuit boards are opposite.

According to a further aspect of the flexible display screen of the invention, in each pair of the magnets disposed on the respective jointing sides of two adjoining flexible circuit boards, one magnet is fixed on one of the flexible circuit boards at its the north pole with its south pole outward orientated, while the other magnet is fixed on the other one of the flexible circuit boards at its south pole with its north pole outward orientated.

According to a further aspect of the flexible display screen of the invention, said display chips are LED chips, OLED chips or LCD chips.

According to a further aspect of the flexible display screen of the invention, the magnets on the perimeter of the back face of the flexible circuit board is disposed with a same interval between each other.

According to a further aspect of the flexible display screen of the invention, said magnets are magnetic irons, magnetic steels or magnetic stones.

According to a further aspect of the flexible display screen of the invention, said magnet is of a cylindrical shape.

In the flexible display screen according to the present invention, the jointing sides of two adjoining flexible circuit boards are respectively and symmetrically arranged with magnets of same number but opposite polarity orientations, so that a large magnetic attraction is generated between two adjoining flexible circuit boards. Therefore, during the assembly of the flexible display screen according to the present invention, each flexible display module can be guided to joint with each other under the action of a specially-arranged magnetic attraction, avoiding the mis-arrangement during the assembly, so as to realize an easy and correct assembly. Furthermore, under the action of the magnetic attraction, the gap between the adjoining flexible display modules is reduced, allowing a larger tension of the flexible display module when it is attached to the medium, so as to improve the display effect of the flexible display screen and the overall quality and the visualization of the product.

### BRIEF DESCRIPTION OF THE ACCOMPANYING DRAWINGS

Fig.1A is a bottom view of the flexible display module according to the prior art;

Fig.1B is a side view of the flexible display module according to the prior art;

Fig.2 is a schematic view showing the jointing of two flexible display modules of the flexible display screen according to the prior art;

Fig.3 is a principle view showing the magnetic force between the flexible display modules of the flexible display screen according to the prior art;

Fig.4 is a schematic view showing the structure of a flexible display screen according to the first embodiment of the present invention;

Fig.5 is a schematic view showing the jointing of two flexible display modules of the flexible display screen according to the first embodiment of the present invention;

Fig.6 is a principle view showing the magnetic force between the flexible display modules of the flexible display screen according to the present invention;

Fig.7 a schematic view showing the structure of a flexible display screen according to the second embodiment of the present invention.

### DETAILED DESCRIPTION OF THE PREFERRED EMBODIMENT

The objects, technical solutions and advantages of the invention can become more evident through below descriptions of the examplary embodiments of the invention with the reference of the accompanying drawings. It should be understood that the embodiments described here are merely for the explanation but not the limit to the invention.

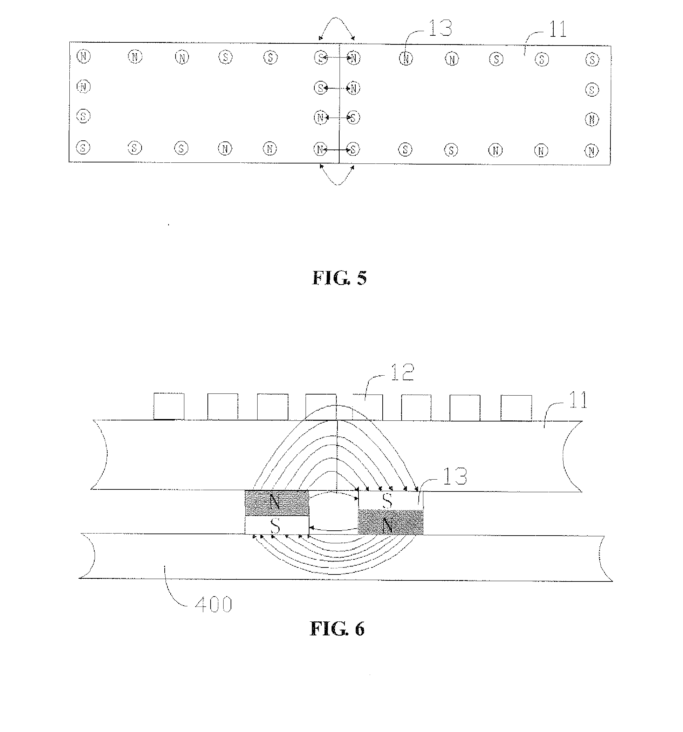

As shown in Figs.4-6, a flexible display screen 100 according to the invention is composed of a number of flexible display modules 10 jointed to each other side by side. The flexible display module 10 comprises a flexible circuit board 11 such as a flexible PCB (Printed Circuit Board). The respective flexible circuit board 11 can be of same shape or different shape. A plurality of flexible circuit boards 11 can be jointed side by side to form the flexible display screen 100. Preferably, the flexible circuit board 11 is of a polygonal shape, although a round shape or any other irregular shape is also allowable. Display chips 12 are fixed on the front face of the flexible circuit board 11, which can be LED (Light Emitting Diode) chips, OLED (Organic Light Emitting Diode) chips or LCD (Liquid Crystal Display) chips, preferably be the LED chips. Magnets 13 are fixed on the back face of the flexible circuit board 11, which can be magnetic irons, magnetic steels, magnetic stones or other magnetic medium. Preferably, the magnet 13 has a cylindrical shape. The flexible display screen 100 can be attracted on a metal medium 400 by these magnets 13.

It is important that the magnets 13 are distributed at least along the perimeter of the back face of each of the flexible circuit boards 11, such that the jointing sides of two adjoining flexible circuit boards 11 are respectively and symmetrically arranged with a same number of magnets 13 but with opposite polarity orientations. In particularly, in a pair of magnets 13 arranged on the respective jointing sides of said two adjoining flexible circuit boards 11, one of the magnets 13 is fixed on the corresponding flexible circuit board 11 at its north pole N with its south pole S outward orientated, while the other one of the magnets 13 is fixed on the corresponding flexible circuit board 11 at its the south pole S of with its north pole N outward orientated, so that a large magnetic attraction force is generated between the two adjoining flexible circuit boards 11, enabling thus an easy and correct joint of the respective flexible display module 10 and a reduced gap between the adjoining flexible circuit boards 11.

In fact, in addition to the perimeter of the flexible circuit board 11, one or more magnets 13 can also be arranged in the middle portion of the flexible circuit board 11, so that the flexible circuit board 11 can be better fixed on the metal medium 400, which can be a metal sheet fixed on a carrier such as a building or the like.

The flexible circuit board 11 is preferably of a square shape or a rectangular shape, although a triangular shape or a trapezoid shape, etc is also allowable. The flexible circuit boards 11 in Figs.4-6 are of rectangular shapes with same size. Each side of the back face of the flexible circuit board 11 is arranged with an even number of magnets 13 in such a way that the number of the magnets 13 of opposite polarity orientations are same while the intervals between the adjacent magnets 13 are same, so that a uniform attraction force is generated between the adjoining flexible circuit boards 11, allowing thus a more compact joint for each flexible display module 10. In the current embodiment, six magnets 13 are evenly distributed on each of the upper and the lower sides of a rectangular flexible circuit board 11, with three magnets 13 arranged outwardly at their north poles N and the other three magnets 13 arranged outwardly at their south poles S. Four magnets 13 are evenly distributed on each of the left and the right sides of the same rectangular flexible circuit board 11, with two magnets 13 arranged outwardly at their north poles N and the other two magnets 13 arranged outwardly at their south poles S. The upper side of the flexible circuit board 11 has a common magnet 13 with each of the left and right sides, i.e., two magnets 13 at the extremity ends of the upper side of the flexible circuit board 11 are the common magnets. Furthermore, the lower side of the flexible circuit board 11 also has a common magnet 13 with each of the left and right sides, i.e., two magnets 13 at the extremity ends of the lower side of the flexible circuit board 11 are the common magnets. Finally, nine flexible display modules 10 are jointed side by side in a 3*3 matrix to form the flexible display screen 100 as shown in Fig. 4, wherein and said matrix of flexible display modules 10 is tensioned due to the larger attraction force formed between the adjoining flexible display modules 10.

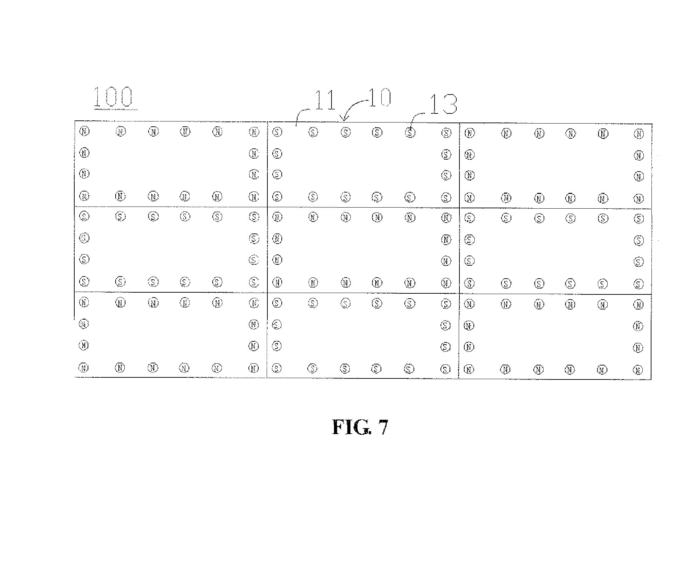

Fig.7 shows the structure of the flexible display screen of a second embodiment according to the invention, which is different from the first embodiment in that the perimeters of the back faces of the flexible circuit boards 11 of a portion of the flexible display modules 10 composing the flexible display screen are arranged with the magnets 13 of one polarity, while the perimeters of the back faces of the flexible circuit boards 11 of the other flexible display modules 10 composing the flexible display screen are arranged with the magnets 13 of the other polarity. In particularly the current embodiment, the flexible display screen has altogether 3*3=9 flexible display modules 10, wherein the magnets 13 on the flexible circuit boards 11 of five flexible display modules 10 are all orientated outward at the north poles N, while the magnets 13 on the flexible circuit boards 11 of the other four flexible display modules 10 are all orientated outward at the south poles S. The nine flexible display modules 10 are jointed with their magnetic orientations crisscross to form the flexible display screen 100 as shown in Fig.7. In fact, the magnetic orientations of the magnets 13 on the flexible circuit 11 of the flexible display module 10 can be designed depending on real demands, with only satisfying that the jointing sides of two adjoining flexible circuit boards 11 are respectively and symmetrically arranged with a same number of magnets 13 with opposite polarity orientations.

In all, in the flexible display screen according to the present invention, the jointing sides of two adjoining flexible circuit boards are respectively and symmetrically arranged with magnets of same number but opposite polarity orientations, so that a large magnetic attraction is generated between two adjoining flexible circuit boards. Therefore, during the assembly of the flexible display screen according to the present invention, each flexible display module can be guided to joint with each other under the action of a specially-arranged magnetic attraction, avoiding the mis-arrangement during the assembly, so as to realize an easy and correct assembly. Furthermore, under the action of the magnetic attraction, the gap between the adjoining flexible display modules is reduced, allowing a larger tension of the flexible display module when it is attached to the medium, so as to improve the display effect of the flexible display screen and the overall quality and the visualization of the product.

Although several preferred embodiments of the present invention have been described, the present invention may be used with other configurations. It will be appreciated by those skilled in the art that, the present invention could have many other embodiments, and changes and modifications may be made thereto without departing from the invention in its broader aspects and as set forth in the following claims and equivalents thereof.

## Claims

1. A flexible display screen composed of a plurality of flexible display modules jointed side by side, each of said flexible display modules comprising a flexible circuit board, which is fixedly arranged with a plurality of display chips on its front face, and a plurality of magnets on its back face, so that said flexible display screen can be attracted on a metal medium by means of said magnets, wherein the magnets are distributed at least on the perimeter of the back face of the flexible circuit board in such a way that the joining sides of two adjoining flexible circuit boards are arranged respectively and symmetrically with a same number of magnets, and each pair of magnets disposed on the respective joining sides having opposite polarity orientations.

2. The flexible display screen according to Claim 1, wherein said flexible display screen is formed by jointing side by side the flexible circuit boards of said flexible display modules.

3. The flexible display screen according to Claim 2, wherein at least one flexible circuit board is configured to have a polygonal shape.

4. The flexible display screen according to Claim 2, wherein at least one flexible circuit board is configured to have a rectangular shape or a square shape.

5. The flexible display screen according to Claim 2, wherein each side of the back face of the flexible circuit board is arranged with an even number of magnets, in which the numbers of the magnets with different polarity orientations are same.

6. The flexible display screen according to Claim 2, wherein the polarity orientations of the magnets arranged on the perimeter of the back face of each single flexible circuit board are same, while the polarity orientations of the magnets on the perimeters of the back faces of two adjoining flexible circuit boards are opposite.

7. The flexible display screen according to Claim 1, wherein in each pair of the magnets disposed on the respective jointing sides of two adjoining flexible circuit boards, one magnet is fixed on one of the flexible circuit boards at its the north pole with its south pole outward orientated, while the other magnet is fixed on the other one of the flexible circuit boards at its south pole with its north pole outward orientated.

8. The flexible display screen according to Claim 1, wherein said display chips are LED chips, OLED chips or LCD chips.

9. The flexible display screen according to Claim 1, wherein the magnets on the perimeter of the back face of the flexible circuit board is disposed with a same interval between each other.

10. The flexible display screen according to Claim 1, wherein said magnets are magnetic irons, magnetic steels or magnetic stones.

11. The flexible display screen according to Claim 1, wherein said magnet is of a cylindrical shape.
